# EUROPÄISCHE PATENTSCHRIFT

(11) **EP 3 931 930 B1**
(45) Veröffentlichungstag und Bekanntmachung des Hinweises auf die Patenterteilung: **09.12.2026**
(21) Anmeldenummer: 20711029.7
(22) Anmeldetag: 28.02.2020
(51) Int. Cl.: H02J 9/00, H02J 1/082, B60L 3/04, H02J 7/60, H02J 7/00

(54) **AKKUMULATORSYSTEM MIT EINEM LEISTUNGSAKKUMULATOR FÜR FAHRBARE ARBEITSMASCHINEN**
ACCUMULATOR SYSTEM WITH A POWER ACCUMULATOR FOR MOBILE WORKING MACHINES
SYSTÈME D'ACCUMULATEUR AVEC UN ACCUMULATEUR DE PUISSANCE POUR MACHINES DE TRAVAIL MOBILES

(30) Priorität: 01.03.2019 AT 501642019
(43) Veröffentlichungstag der Anmeldung: 05.01.2022
(73) Patentinhaber: Wacker Neuson Linz GmbH, 4063 Hörsching (AT)
(72) Erfinder: THUMFART, Harald, 4175 Herzogsdorf (AT); RECHEIS, Manes, 4063 Hörsching (AT); FINZEL, Robert, 4060 Leonding (AT); ERLINGER, Thomas, 4175 Herzogsdorf (AT); KRÖPL, Christian, 4470 Enns (AT); LEIBETSEDER, Oliver, 4040 Linz (AT)
(74) Vertreter: Hübscher & Partner Patentanwälte GmbH
(86) Internationale Anmeldenummer: PCT/AT2020/060056
(87) Internationale Veröffentlichungsnummer: WO 2020/176915

(56) Entgegenhaltungen:
- EP-A1- 3 444 915
- DE-A1- 102013 114 545
- DE-A1- 102014 204 473

## Beschreibung

### Technisches Gebiet

Die Erfindung bezieht sich auf ein Akkumulatorsystem gemäß dem Oberbegriff des Anspruchs 1. Die Erfindung betrifft auch ein Verfahren zum Betreiben eines solchen Akkumulatorsystems und einer akkumulatorsystemexternen Schaltung.

### Stand der Technik

Ein Akkumulatorsystem mit einer Standby-Schaltung ist beispielsweise aus dem Dokument EP 3 444 915 A1 als bekannt zu entnehmen.

Erfolgt eine Versorgung von Arbeitsmaschinen mit elektrischer Energie aus einem Hochleistungs(-spanungs-)akku ist es bekannt die 12/24V Bordstromversorgung des Fahrzeuges bzw. der Arbeitsmaschine mittels eines separaten, externen Energiespeichers, beispielsweise einer Bordbatterie, zu gewährleisten (EP 2 031 135 A1). Der externe Energiespeicher kann von dem Batteriesystem über einen DC-DC-Wandler oder über einen im Antriebsstrang der Arbeitsmaschine vorgesehenen Generator nachgeladen werden. Die Bezeichnung Hochleistung bezieht sich im vorliegenden Fall auf einen Gleichstromkreis, über den Antriebsleistungen übertragen werden können. Dieser muss nicht unbedingt höhere Spannungen als das Bordnetz führen, überträgt aber wesentlich höhere Leistungen als das 12/24V Niederspannungsbordnetz. Eine Verbindung einer Fahrzeugsteuerung mit einem Datenbus eines Leistungsakkumulators ist beispielsweise aus der DE 10 2013 114 545 A9 bekannt.

Derartige bekannte Akkumulatorsysteme dienen der Hauptbereitstellung der Antriebsenergie, also der Versorgung eines Hochleistungsnetzes, sowie der elektrischen Ladung der Bordbatterie und damit der Versorgung der Bordelektronik der Arbeitsmaschine, welche für die Freigabe der Antriebsleistung im Hochleistungsnetz verantwortlich zeichnet. Der Datenbus dient der Kommunikation zwischen Niederspannungsbordnetz und Akkumulatorsystem. Zur Herstellung eines sicheren stromlosen Zustandes kann die elektrische Verbindung zwischen der Arbeitsmaschine und dem Leistungsakkumulator üblicherweise über einen Batterietrennschalter getrennt werden.

Bekannte Akkumulatorsysteme bestehen aus einem oder mehreren Modulen die über einen internen Baten-Bus mit einer Überwachungselektronik, dem Kontroller, verbunden sind. Der Kontroller des Akkumulatorsystems wird bei bekannten systemen vom der Arbeitsmaschine zugeordneten externen Energiespeicher, also von der Bordbatterie, mit Energie versorgt, womit sich der Kontroller bei Betätigung des Zündschalters der Arbeitsmaschine starten bzw. hochfahren lässt.

Der Kontroller steuert neben den Überwachungsaufgaben und der Kommunikation nach außen die Freigabe der Schalter der Leitungsanschlüsse. Eine Freigabe der Antriebsversorgung erfolgt also über das Niederspannungsbordnetz, das aktiviert wird, wenn ein Benutzer die Arbeitsmaschine startet und in Betrieb nimmt. Das diesbezügliche Signal muss nicht zwingend von einem Schlüsselschalter kommen, wird jedoch meist direkt über einen Schlüsselschalter bereitgestellt.

Solange die Antriebsleistung aus der Antriebsbatterie noch nicht freigegeben ist wird das Fahrzeug, das Gerät oder die Maschine aus der externen Energiequelle mit Energie versorgt. Nach Freigabe der Antriebsleistung kann eine Nachspeisung von Energie aus dem Leistungsakkumulator in das Niederspannungsbordnetz sowie das Nachladen des externen Niederspannungsenergiespeichers erfolgen.

Die externe Energiequelle ist die initiale Energiequelle zum Starten des Hochleistungsnetzes, indem sie Energie für eine Kommunikation, ein Schließen von Schaltern, Versorgung von Anzeigen u. dgl. liefert, bis der Leistungsakkumulator zugeschaltet ist und damit die primäre Energieversorgung der Maschine übernimmt. Die externe Energiequelle dient auch der Energiebereitstellung für Standlicht und Warnblinkanlage, für Anzeigen und Lampen, solange der Leistungsakkumulator noch nicht, beispielsweise durch Betätigung eines Schlüsselschalters, freigegeben ist.

Das Batteriemanagementsystem wird somit stets von außen, von der externen Energiequelle, mit Energie versorgt. Ohne externe Energiequelle kann der Leistungsakkumulator nicht aktiviert werden. Ein Gerät, ein Fahrzeug oder eine Maschine mit funktionstüchtigem Leistungsakkumulator aber leerer Bordbatterie ist funktionsunfähig und nur durch Fremdhilfe erneut startbar.

Für ein Stillsetzen bzw. sicheres Ausschalten der Elektrik einer Maschine über einen längeren Zeitraum von wenigen Stunden bis zu mehreren Monaten ist üblicherweise der Batterietrennschalter der Maschine manuell zu betätigen. Das bedeutet, um sicher zu gehen, dass die Batterie bei Standzeiten nicht unnötig entladen wird ist ein manueller Eingriff notwendig. Ein automatisches Abschalten ist nicht möglich.

Da die Bordbatterie elektrisch direkt mit der Fahrzeugmasse verbunden ist, besteht bei elektrischen Arbeiten sowie im Fehlerfall stets ein hohes Kurzschlussrisiko wegen des geringen Innenwiderstandes der Bordbatterie. Als Bordbatterien werden beispielsweise 12V oder 24V Starterbatterien verwendet. Diese bedingen zusätzlichen Kosten und müssen als Verschleißteile rund alle 4-6 Jahre getauscht werden. Zusätzlich verbraucht die Bordbatterie ständig Energie, da sie stets nachgeladen werden muss, sowie weiteren Bauraum, der bei kleinen Geräten, Maschinen sowie Fahrzeugen oft sehr begrenzt ist.

Bei abgeschaltetem Leistungsakkumulator können Standlichter, Scheinwerfer und Warnblinkanlangen der Arbeitsmaschine nur von der Bordbatterie versorgt werden. Je nach Anwendungsfall kann die maximale Betriebszeit weniger als 30 Minuten bis hin zu wenigen Stunden betragen. Diese Verbraucher können die Batterie sehr rasch soweit tiefentleeren, dass eine Inbetriebnahme des Leistungsakkumulators ohne fremde Hilfe oder Austausch der Bordbatterie gar nicht mehr möglich ist.

### Darstellung der Erfindung

Der Erfindung liegt somit die Aufgabe zugrunde, ein Akkumulatorsystem der eingangs geschilderten Art anzugeben, das die vorgenannten Nachteile vermeidet und ohne Bordbatterie in Betrieb genommen werden kann.

Gemäß der Erfindung werden ein Akkumulatorsystem sowie ein Verfahren mit den Merkmalen des jeweiligen unabhängigen Anspruchs bereitgestellt. Vorteilhafte Ausgestaltungen der Erfindung sind Gegenstand der abhängigen Ansprüche.

Die Erfindung löst die gestellte Aufgabe dadurch, dass das Batteriemanagementsystem zur Spannungsversorgung einen dem Kontroller vorgeschalteten Gleichstromwandler umfasst, der über eine Standby-Schaltung an den Leistungsakkumulator angeschlossen ist, wobei die Standby-Schaltung über eine akkumulatorsystemexterne Schaltung aktivierbar ist.

Ein derartiges Akkumulatorsystem kann ohne Bordbatterie in Betrieb genommen werden, wobei eine Bedienung, ein Starten und eine Stromversorgung der Arbeitsmaschine für einen Bediener im Vergleich zum Stand der Technik unverändert funktioniert. Beim Starten der Arbeitsmaschine mit einem Zündschloss od. dgl. und bei der Betätigung von Verbrauchern bekommt ein Benutzer sofort eine optische bzw. funktionelle Rückmeldung darüber, ob die Arbeitsmaschine in Betrieb genommen worden ist. Dazu ist es jedoch notwendig das Batteriemanagementsystem bei Inbetriebnahme aufzuwecken und zu aktivieren, was mit Hilfe der Antriebsbatterie über die Standby-Schaltung bewerkstelligt wird. Das erfindungsgemäße Akkumulatorsystem benötigt zur Inbetriebnahme keine externe Stromversorgung. Zur Versorgung der Überwachungselektronik wird der Gleichstromwandler des Akkumulatorsystems verwendet. Dieses wird auf bei Anforderung durch einen Benutzer oder auf Anforderung durch anderen Komponenten, wie beispielsweise Ladegeräte, Fernsteuerungen od. dgl. aktiviert. Damit der der Kontroller erkennt, mit welcher externen Schaltung (Schlüssel, Ladegerät etc.) die Inbetriebnahme erfolgte können bei einer besonders einfachen Lösung für diesen Zweck zwei oder mehrere Leitungen vorgesehen sein. Es wäre aber auch ein Bussystem denkbar. Erfolgt die Inbetriebnahme durch ein Ladegerät, so kann dieses die erforderlichen, vom Kontroller des Batteriemanagementsystems per Datenbus angeforderten Ladeströme bzw. Ladekurven liefern. Bei dem Gleichstromwandler handelt es sich um ein Bauteil, welches die Spannung des Leistungsakkumulators auf ein benötigtes Spannungsniveau, beispielsweise die Bordspannung, bringt. Es kann sich dabei auch um einen Spannungsteiler oder Linearspannungsregler handeln.

Bevorzugt wird das erfindungsgemäße Akkumulatorsystem in mobilen Arbeitsmaschinen mit einer Arbeitsvorrichtung eingesetzt. Dies können beispielsweise Radlader, Bagger oder Teleskoplader sein. Dabei ist mindestens eine Arbeitsfunktion der Arbeitsvorrichtung, wie beispielsweise Heben/Senken, Einfahren/Ausfahren eines Hubarms mittels mindestens eines Elektromotors angetrieben. Der Elektromotor kann dabei direkt auf ein Element der Arbeitsvorrichtung wirken oder mittels einer Hydraulikpumpe ein hydraulisches Element wie beispielsweise einen Hydromotor oder eine Kolben-/Zylinder-Einheit antreiben. Bei der Arbeitsvorrichtung kann es sich um einen Hubarm handeln, wie er beispielsweise von Radladern, Teleskopladern oder Baggern aus dem Stand der Technik bekannt ist. Üblicherweise werden derartige Arbeitsmaschinen sowie deren Arbeitsvorrichtungen zum Bewegen oder Transport von Material wie beispielsweise Schüttgut (Sand, Erde) genutzt.

Bei der Anforderung durch einen Benutzer oder durch andere Komponenten kann es sich um ein Dauersignal oder einen Impuls handeln. Bevorzugt wird jedoch, um die Batterie z.B. vor Tiefentladung bei Kabelfehler zu schützen, über eine geschickte elektronische Schaltung die entsprechende Leitung, über welche die Anforderung erfolgte, hochohmig gemacht. Dadurch wird ein Signal einer Daueranforderung mit dieser Schaltung in einen Impuls umgeformt.

Der Gleichstromwandler stellt, bis der Leistungsakkumulator freigegeben ist die Konstantversorgung (Entspricht einer eingeschalteten Zündung eines herkömmlichen Fahrzeuges) des Bordnetzes zur Verfügung. Der interne Gleichstromwandler ist vorzugsweise gegen Überlast von außen abgesichert. Die Freigabe der Versorgung des Bordnetzes erfolgt im Gegensatz zum Stand der Technik vom Batteriemanagementsystem her.

Ein aktivieren des Leistungsakkumulators z.B. durch Betätigen eines Schlüsselschalters, erfolgt durch das Batteriemanagementsystem, das nach seiner Aktivierung eine Selbstprüfung durchführt und eine Halte-Schaltung aktiviert. Dadurch kann sich das Batteriemanagementsystem auch wieder selbst ausschalten, wenn die Anforderung von außen unterbrochen wird. Die Versorgung des Bordnetzes mit Dauerplus wird von der Standby-Schaltung aktiviert, aus Sicherheitsgründen jedoch nur für einige Sekunden, bis der Controller gebootet hat und dieser in weiterer Folge die Halterfunktion übernimmt. Dadurch ist sichergestellt, dass sich der Akku bei fehlerbedingter Daueranforderung selbst deaktivieren kann.

Damit auch die Warnblinkanlage sowie Standlichter z.B. ohne Zündschlüssel die Batterie-Elektronik aufwecken können gibt es separate Eingangsbeschaltungen, in Abhängigkeit deren Aktivierung das Batteriemanagementsystem gezielt Anschlüsse freigeben kann. Für einen Notbetrieb mit einer Warnblinkanlage und mit Standlicht steht somit durch die Antriebsbatterie eine viel größere Energiequelle zur Verfügung, als dies bei den bekannten Lösungen mit meist sehr kleiner Niedervoltbatterie der Fall ist und verlängert damit die maximale Einsatzzeit im Wartungsfall oder im Falle einer Panne. Durch das automatische Abschalten des Leistungsakkumulators durch das Batteriemanagementsystem bei deaktivierter akkumulatorsystemexterner Schaltung kann bei Stillegung der Arbeitsmaschine auf ein manuelle Wegschalten des Leistungsakkumulators verzichtet werden. Die Maschine ist also immer automatisch für längere Standzeiten vorbereitet. Dadurch, dass die Antriebsbatterie von der Niedervoltseite isoliert ist, kann auf der Niedervoltseite in der Bordelektronik auf eine Stromquelle mit hohen Kurzschlussströmen und geringem Innenwiderstand verzichtet werden. Da Gleichstromwandler und Ladegeräte des Akkumulatorsystems strombegrenzt sind, sind auch keine Kurzschlüsse zu befürchten. Für Elektrikarbeiten und im Fehlerfall ist das Risiko von Verletzungen und Brandgefahr durch Kurzschlüsse auf der Niedervoltseite stark verringert.

Um die Sicherheit zu gewährleisten wird vorgeschlagen, dass in einen Schaltkreis, der neben dem Leistungakkumulator wenigstens die Standby-Schaltung, den Kontroller und die akkumulatorexterne Schaltung umfasst, zur Absicherung gegen Überspannungen, unbeabsichtigtes Entladen bzw. Tiefentladen und/oder Fehlsignale eine Sicherheitsschaltung integriert ist. Für eine separate Stromversorgung z.B. einer Warnblinkanlage oder von Beleuchtungen ohne Freigabe von Antriebskomponenten kann ein zusätzlicher Hochleistungsausgang vorgesehen sein, der einem geschalteten Plus (Klemme 15), eines herkömmlichen Fahrzeuges entspricht und der auf Anforderung vom Kontroller freigegeben wird. Alle Signalleitungen werden bevorzugt durch eine Sicherheitsschaltung geführt.

Es ist erfindungsgemäß vorgesehen, dass wenigstens zwei Leitungsanschlüsse vorgesehen sind, wobei wenigstens einer einen direkt an den Leistungsakkumulator angeschlossenen Hochspannungsanschluss und wenigstens ein anderer einen an den Gleichstromwandler angeschlossenen Niederspannungsanschluss ausbildet.

Zudem ist vorgesehen, dass der Hochspannungsanschluss und/oder der Niederspannungsanschluss je wenigstens zwei über Schalter schaltbare Leitungsanschlüsse umfasst, von denen wenigstens einer in einer Bereitschaftsstellung der Arbeitsmaschine vom Kontroller aktiv geschaltet ist und von denen alle in einer Arbeitsstellung vom Kontroller aktiv geschaltet sind.

Des Weiteren betrifft die Erfindung ein Fahrzeug mit einem Akkumulatorsystem und mit einer akkumulatorsystemexternen Schaltung, die eine Schlüsselschaltung, eine Ladeschaltung, eine Bereitschaftsschaltung und/oder eine Notfallschaltung ist.

### Kurze Beschreibung der Erfindung

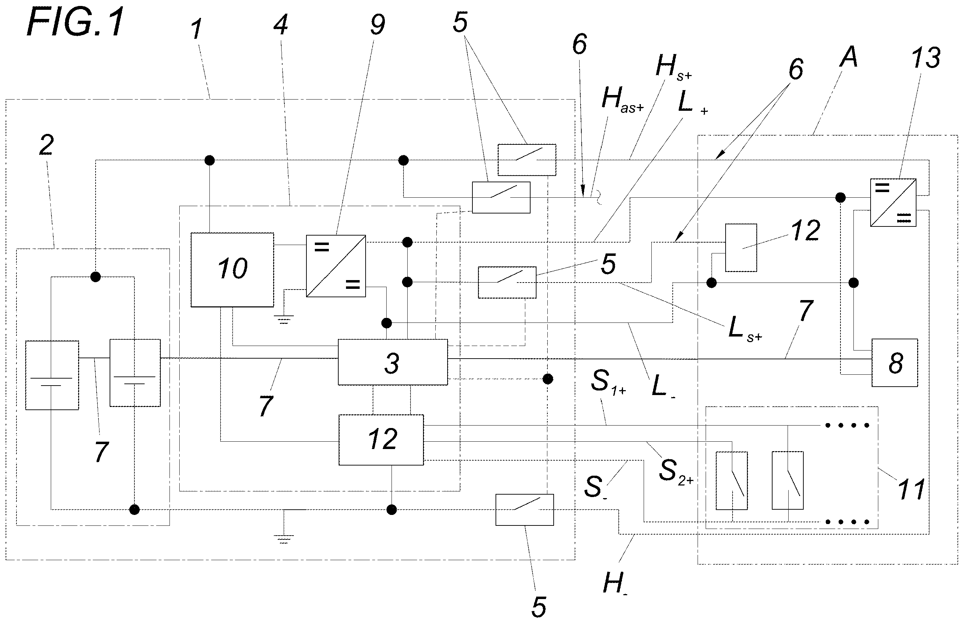

In der Zeichnung ist der Erfindungsgegenstand beispielsweise dargestellt. Es zeigen
- Fig. 1: ein schematisches Schaltbild eines an eine Arbeitsmaschine angeschlossenen Akkumulatorsystems,

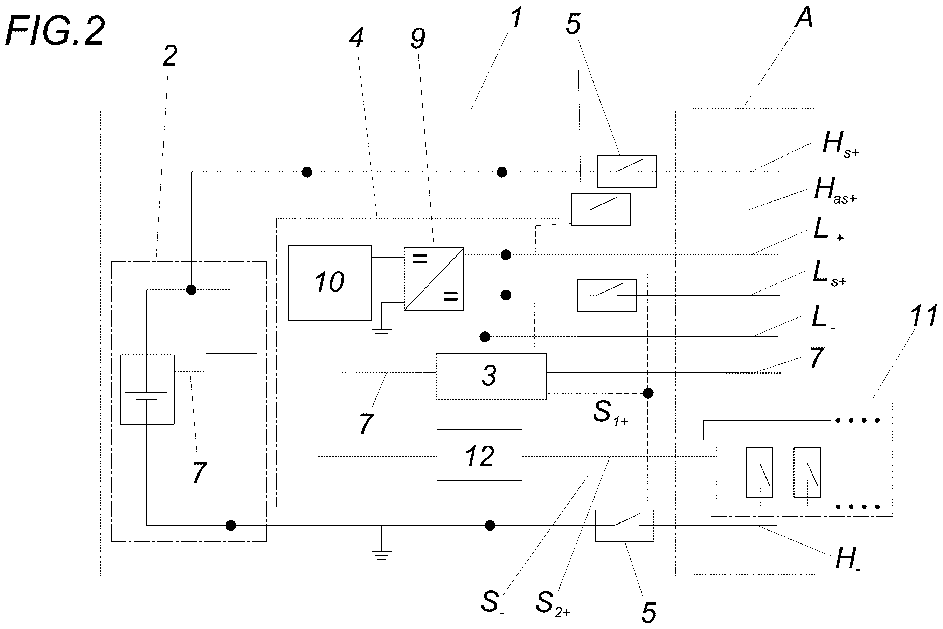

- Fig. 2: das Schaltbild des Akkumulatorsystem aus Fig. 1 und

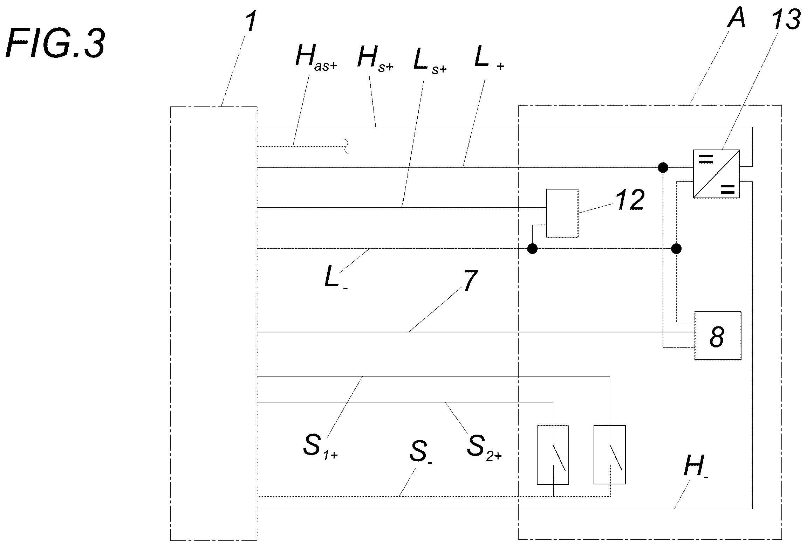

- Fig. 3: das Schaltbild der Arbeitsmaschine aus Fig. 1.

### Wege zur Ausführung der Erfindung

Das Akkumulatorsystem 1, das insbesondere auswechselbar von einer Arbeitsmaschine A aufgenommen werden kann, umfasst einen Leistungsakkumulator 2, der entsprechende Antriebsleistungen bereitstellt, ein einen Kontroller 3 aufweisendes Batteriemanagementsystem 4, mittels Schalter 5 schaltbare Leitungsanschlüssen 6 und einen Datenbus 7 zur Verbindung mit einer Arbeitsmaschinensteuerung 8. Erfindungsgemäß weist das Batteriemanagementsystem 4 zur Spannungsversorgung des Kontrollers 3 einen dem Kontroller 3 vorgeschalteten Gleichstromwandler 9 auf, der zwecks Spannungsversorgung des Kontrollers 3 über eine Standby-Schaltung 10 an den Leistungsakkumulator 2 angeschlossen ist. Die Standby-Schaltung 10 ist über eine akkumulatorsystemexterne Schaltung 11 aktivierbar.

In einen Schaltkreis, der neben dem Leistungakkumulator 2 wenigstens die Standby-Schaltung 10, den Kontroller 3 und die akkumulatorexterne Schaltung 11 umfasst, ist zur Absicherung gegen Überspannungen, gegen unbeabsichtigtes Entladen bzw. Tiefentladen und/oder gegen Einspeisung von Fehlsignale eine Sicherheitsschaltung 12 integriert.

Es sind mehrere Leitungsanschlüsse (6) vorgesehen, wobei zwei direkt an den Leistungsakkumulator (2) angeschlossene, mittels Schalter 5 schaltbare Hochspannungsanschlüsse H_{S+}, H_{AS+,} zur Hochleistungsversorgung der Arbeitsmaschine A und zwei an einen Gleichstromwandler 9 angeschlossenen Niederspannungsanschlüsse L₊, L_{S+}, zur Energieversorgung der Bordelektronik der Arbeitsmaschine A vorgesehen sind. Der Gleichstromwandler 9 dient auch der Energieversorgung des Kontrollers 3 bei aktivierter Standby-Schaltung 10.

Der Hochspannungsanschluss und/oder der Niederspannungsanschluss je wenigstens zwei über Schalter 5 schaltbare Leitungsanschlüsse (6) umfasst, von denen wenigstens einer der Leitungsanschlüsse 6 in einer Bereitschaftsstellung der Arbeitsmaschine vom Kontroller 3 aktiv geschaltet ist, um die Bordelektronik der Arbeitsmaschine mit Energie zu versorgen und um eine Inbetriebnahme der Arbeitsmaschine zu ermöglichen. In einer Arbeitsstellung können alle Schalter 5 vom Kontroller 5 aktiv geschaltet werden.

Ein Fahrzeug, insbesondere eine selbstfahrende Arbeitsmaschine ist mit einem derartigen Akkumulatorsystem und mit einer akkumulatorsystemexternen Schaltung 11 zur Inbetriebnahme des Akkumulatorsystems ausgestattet, wobei die akkumulatorsystemexterne Schaltung 11 eine Schlüsselschaltung, eine Ladeschaltung, eine Bereitschaftsschaltung und/oder eine Notfallschaltung ist.

Für eine Inbetriebnahme eines erfindungsgemäßen Akkumulatorsystems mit einer akkumulatorsystemexternen Schaltung 11 wird zunächst die Standby-Schaltung 10 durch Betätigung der akkumulatorsystemexternen Schaltung 11 aktiviert, wonach die Standby-Schaltung 10 den Gleichstromwandler 9 und den Kontroller 3 mit Spannung versorgt und wonach in Abhängigkeit des Signals der akkumulatorsystemexternen Schaltung 11 Leitungsanschlüsse 6 über die zugeordneten Schalter 5 selektiv freigegeben werden. Zudem kann der Kontroller 3 in Abhängigkeit des Signals der akkumulatorsystemexternen Schaltung 11 nach einem Hochfahren des Batteriemanagementsystems 4 über den Datenbus 7 mit der Arbeitsmaschinensteuerung 8 und gegebenenfalls mit weiteren Komponenten, wie beispielsweise einem Ladegerät und/oder einem Inverter, steuerungsverbunden werden. Das Batteriemanagementsystems 4 erkennt also, ob die Arbeitsmaschine beispielsweise in Betrieb genommen oder geladen werden soll und aktiviert die entsprechenden Funktionen.

Die Standby-Schaltung 10 wird mittels eines Signales von der akkumulatorsystemexterne Schaltung 11 aktiviert. Das Signal kann ein Dauersignal oder ein Impuls sein.

Das Bordnetz umfasst naturgemäß eine Vielzahl an Verbrauchern 12, von denen aber nur einer angedeutet ist. Der Gleichstromwandler 13 des Bordnetzes hat primär und sekundärseitig je zwei Anschlüsse, um die Bezugspotentiale von Arbeitsmaschine A und Akkumulatorsystem 1 elektrisch verbunden verbinden zu können.

## Patentansprüche

1. Akkumulatorsystem (1) für fahrbare Arbeitsmaschinen, mit einem Leistungsakkumulator (2), mit einem einen Kontroller (3) aufweisenden Batteriemanagementsystem (4), mit mittels Schaltern (5) schaltbaren Leitungsanschlüssen (6) und mit einem Datenbus (7) zur Verbindung mit einer Arbeitsmaschinensteuerung (8), wobei das Batteriemanagementsystem (4) zur Spannungsversorgung einen dem Kontroller (3) vorgeschalteten Gleichstromwandler (9) umfasst, der über eine Standby-Schaltung (10) an den Leistungsakkumulator (2) angeschlossen ist, **dadurch gekennzeichnet, dass** die Standby-Schaltung (10) zur bordbatteriefreien Inbetriebnahme über eine akkumulatorsystemexterne Schaltung (11) aktivierbar ist, wobei wenigstens zwei Leitungsanschlüsse (6) vorgesehen sind, wobei wenigstens einer der Leitungsanschlüsse (6) einen direkt an den Leistungsakkumulator (2) angeschlossenen Hochspannungsanschluss und wenigstens ein anderer der Leitungsanschlüsse (6) einen an der Gleichstromwandler (9) angeschlossenen Niederspannungsanschluss ausbildet, und wobei der Hochspannungsanschluss und/oder der Niederspannungsanschluss je wenigstens zwei über Schalter (5) schaltbare Leitungsanschlüsse (6) umfasst, von denen wenigstens einer in einer Bereitschaftsstellung der Arbeitsmaschine vom Kontroller (3) aktiv geschaltet ist und von denen alle in einer Arbeitsstellung der Arbeitsmaschine vom Kontroller (3) aktiv geschaltet sind.

2. Akkumulatorsystem nach Anspruch 1, **dadurch gekennzeichnet, dass** das Akkumulatorsystem zum Ausbilden eines Schaltkreises mit der akkumulatorsystemexternen Schaltung ausgebildet ist, wobei der Schaltkreis neben dem Leistungakkumulator (2) wenigstens die Standby-Schaltung (10), den Kontroller (3) und die akkumulatorexterne Schaltung (11) umfasst, wobei eine Sicherheitsschaltung (12) zur Absicherung gegen Überspannungen, unbeabsichtigtes Entladen bzw. Tiefentladen und/oder Fehlsignale in den Schaltkreis integriert ist.

3. Fahrzeug mit einem Akkumulatorsystem nach einem der Ansprüche 1 oder 2, und mit einer akkumulatorsystemexternen Schaltung (11) zum Aktivieren der Standby-Schaltung (10).

4. Fahrzeug nach Anspruch 3, **dadurch gekennzeichnet, dass** die akkumulatorsystemexterne Schaltung (11) eine Schlüsselschaltung, eine Ladeschaltung, eine Bereitschaftsschaltung und/oder eine Notfallschaltung ist.

5. Verfahren zum Betreiben eines Akkumulatorsystems nach einem der Ansprüche 1 oder 2 in Verbindung mit einer akkumulatorsystemexternen Schaltung (11), wobei zunächst die Standby-Schaltung (10) durch Betätigung der akkumulatorsystemexternen Schaltung (11) aktiviert wird, wonach die Standby-Schaltung (10) den Gleichstromwandler (9) und den Kontroller (3) mit Spannung versorgt, wonach in Abhängigkeit eines Signals der akkumulatorsystemexternen Schaltung (11) die Leitungsanschlüsse (6) über die zugeordneten Schalter (5) selektiv freigegeben werden, wobei der Kontroller (3) in Abhängigkeit des Signals der akkumulatorsystemexternen Schaltung (11) nach einem Hochfahren des Batteriemanagementsystems (4) über den Datenbus (7) mit der Arbeitsmaschinensteuerung (8) und mit weiteren Komponenten insbesondere einem Ladegerät und/oder einem Inverter, steuerungsverbunden wird.

## Claims

1. An accumulator system (1) for mobile working machines, comprising a power accumulator (2), a battery management system (4) having a controller (3), line connections (6) switchable by means of switches (5), and a data bus (7) for connection to a working machine control system (8), wherein the battery management system (4) comprises, for voltage supply, a DC converter (9) connected upstream of the controller (3), said DC converter (9) being connected to the power accumulator (2) via a standby circuit (10), **characterized in that** the standby circuit (10) is activatable via a circuit (11) external to the accumulator system for activation without an on-board battery, wherein at least two line connections (6) are provided, wherein at least one of the line connections (6) forms a high-voltage connection connected directly to the power accumulator (2) and at least another of the line connections (6) forms a low-voltage connection connected to the DC converter (9), and wherein the high-voltage connection and/or the low-voltage connection each comprise at least two line connections (6) switchable by means of switches (5), of which at least one is switched into an active state by the controller (3) in a standby state of the working machine and all of which are switched into an active state by the controller (3) in an operating state of the working machine.

2. Accumulator system according to claim 1, **characterized in that** the accumulator system is configured to form a circuit with the circuit external to the accumulator system, wherein the circuit comprises, in addition to the power accumulator (2), at least the standby circuit (10), the controller (3) and the circuit (11) external to the accumulator system, wherein a safety circuit (12) for protection against overvoltages, unintentional discharging or deep discharging and/or erroneous signals is integrated into the circuit.

3. Vehicle comprising an accumulator system according to claim 1 or 2, and a circuit (11) external to the accumulator system for activating the standby circuit (10).

4. Vehicle according to claim 3, **characterized in that** the circuit (11) external to the accumulator system is a key-operated circuit, a charging circuit, a standby circuit and/or an emergency shutdown circuit.

5. Method for operating an accumulator system according to claim 1 or in conjunction with a circuit (11) external to the accumulator system, wherein the standby circuit (10) is initially activated by actuating the circuit (11) external to the accumulator system, whereupon the standby circuit (10) supplies the DC converter (9) and the controller (3) with voltage, whereupon the line connections (6) are selectively enabled via the associated switches (5) depending on a signal from the circuit (11) external to the accumulator system, wherein the controller (3) is connected for control purposes -depending on the signal from the circuit (11) external to the accumulator system- after start-up of the battery management system (4), via the data bus (7) to the working machine control system (8) and to further components, in particular, to a charging device and/or an inverter.

## Revendications

1. Système d'accumulateur (1) pour engins de travail mobiles, comprenant un accumulateur de puissance (2) et un système de gestion de batterie (4) comportant un contrôleur (3), avec des bornes de raccordement (6) commutables au moyen de commutateurs (5) et avec un bus de données (7) destiné à la connexion à une commande de machine de travail (8), le système de gestion de batterie (4) comprenant, pour l'alimentation en tension, un convertisseur de courant continu (9), monté en amont du contrôleur (3) et relié à l'accumulateur de puissance (2) via un circuit de veille (10),
**caractérisé en ce que** le circuit de veille (10) peut être activé via un circuit (11) externe au système d'accumulateur pour permettre une mise en service sans batterie de bord, au moins deux bornes de raccordement (6) sont prévues, au moins l'une des bornes de raccordement (6) formant une borne haute tension raccordée directement à l'accumulateur de puissance (2) et au moins une autre des bornes de raccordement formant une borne basse tension raccordée au convertisseur de courant continu (9), et
la borne haute tension et/ou la borne basse tension comprenant chacune au moins deux bornes de raccordement commutables via des commutateurs (5), dont au moins une est activée par le contrôleur (3) lorsque la machine de travail est en position de veille et dont toutes sont activées par le contrôleur (3) lorsque la machine de travail est en position de fonctionnement.

2. Système d'accumulateur selon la revendication 1, **caractérisé en ce que** le système d'accumulateur est conçu pour former un circuit avec le circuit externe au système d'accumulateur, ledit circuit comprenant, outre l'accumulateur de puissance (2), au moins le circuit de veille (10), le contrôleur (3) et le circuit externe à l'accumulateur (11), un circuit de sécurité (12) destiné à la protection contre les surtensions, les décharges involontaires ou les décharges profondes et/ou les signaux erronés étant intégré dans le circuit.

3. Véhicule comprenant un système d'accumulateur selon l'une des revendications 1 ou 2, et un circuit (11) externe au système d'accumulateur destiné à activer le circuit de veille (10).

4. Véhicule selon la revendication 3, **caractérisé en ce que** le circuit (11) externe au système d'accumulateur est un circuit à clé, un circuit de charge, un circuit de veille et/ou un circuit d'urgence.

5. Procédé de fonctionnement d'un système d'accumulateur selon l'une des revendications 1 ou en association avec un circuit (11) externe au système d'accumulateur, dans lequel le circuit de veille (10) est d'abord activé par l'actionnement du circuit externe (11) au système de batterie, après quoi le circuit de veille (10) alimente en tension le convertisseur de courant continu (9) et le contrôleur (3) de tension, après quoi, en fonction d'un signal provenant du circuit externe (11) au système d'accumulateur, les bornes de raccordement (6) sont sélectivement libérées via les commutateurs associés (5), le contrôleur (3), en fonction du signal du circuit externe (11) au système d'accumulateur, est relié, après le démarrage du système de gestion de batterie (4), via le bus de données (7), à la commande de la machine de travail (8) et à d'autres composants, notamment un chargeur et/ou un onduleur, pour assurer la commande.
